# EUROPEAN PATENT SPECIFICATION

(11) **EP 3 490 357 B1**
(45) Date of publication and mention of the grant of the patent: **20.10.2021**
(21) Application number: 18189841.2
(22) Date of filing: 21.08.2018
(51) Int. Cl.: H05K 7/20

(54) **LIQUID-COOLED SERVER CHASSIS**
FLÜSSIGKEITSGEKÜHLTES SERVERGEHÄUSE
CHÂSSIS DE SERVEUR REFROIDI PAR LIQUIDE

(30) Priority: 24.11.2017 CN 201711193708
(43) Date of publication of application: 29.05.2019
(73) Proprietor: Beijing Baidu Netcom Science and Technology Co., Ltd., Beijing 100085 (CN)
(72) Inventor: JING, Tangbo, BEIJING, 100085 (CN); SUN, Xiaogang, BEIJING, 100085 (CN); ZHANG, Binghua, BEIJING, 100085 (CN)
(74) Representative: Lavoix

(56) References cited:
- WO-A1-2014/039212
- CN-A- 103 616 940
- US-A- 4 493 010
- US-B2- 8 184 436

## Description

### FIELD OF THE INVENTION

The present invention relates to the field of servers, and in particular to a modular liquid-cooled server chassis.

### BACKGROUND OF THE INVENTION

With the prevalence of big data, cloud computing, and Artificial Intelligence (AI), the requirements for computing at data centers and servers are getting more and more challenging, and it is getting increasingly difficult for computing architectures based on CPU chips to satisfy the analytical processing of big data and model training on artificial intelligence. In addition, heterogeneous computing systems represented by GPUs (Graphic Processing Units), FPGAs (Field Programmable Gate Arrays), and ASICs (Application Specific Integrated Circuits) have great potential for development. With increasing power density, single chips can reach 300W and even 500W or more. Moreover, the density of a single cabinet can reach 40 or even 60kW. The traditional cooling technology for a data center utilizes precise air conditioning in the equipment room and exchanges heat from the server computing chip by the cooling air. The poor heat transfer characteristics of the air itself results in the high heat transfer resistance and the low heat flux density, which cannot satisfy the requirements for heat dissipation regarding the new type of high-density heterogeneous computing and super-computing at data center. In addition, with the rising energy costs and people's attention to environmental protection, energy-saving requirements of servers and data centers are increasingly strong. On the condition of ensuring equipment safety and high-performance operation, how to increase the energy utilization efficiency of data centers and reduce PUE (Power Usage Efficiency) has become one of the goals of the data center infrastructure.

At traditional data centers, refrigeration units provide chilled water to the air-conditioning terminals to continuously cool IT equipment. The energy consumption of the refrigeration unit accounts for about 40% of the energy consumption of the data center. Obviously the energy consumption is severe. Although by selecting a suitable low-temperature environment, partially natural cooling (free cooling) can be achieved through the heat exchanger bypass refrigeration unit to save energy, it requires additional investment and occupies new area, and is limited by the geographical environment and the maximum air inlet temperature of the server resulting in limited effectiveness.

The liquid-cooled technology that directly uses the liquid to cool the server can achieve a higher heat exchange efficiency, thereby cooling the server chip completely without the refrigeration unit, so as to operate the server chip at a higher temperature without limited to the geographical restrictions, and the PUE can reach 1.02 or even lower. Considering the intrinsic factors in the cold-plate liquid-cooled system of the server, such as the risk of water leakage, many fault locations, difficulty in maintenance and so on, the immersed liquid-cooled solution is the best way of cooling to achieve high density and energy saving on the condition of reliability.

The existing immersed liquid-cooled solution is to directly immerse the server chip and other electronics in a non-conductive liquid directly for heat exchange, which may be cooling in a single-phase high-boiling fluorinated liquid or mineral oil, and cooling in a two-phase low-boiling fluorinated liquid.

The single-phase immersed cooling uses convection for its heat transfer, which has the drawbacks such as uneven flow field, low heat exchange efficiency (compared to two-phase immersed cooling), low heat dissipation, and towing loss during the maintenance of IT equipment (that is, the surface of IT equipment is stained with liquid and it is not easy to for the liquid to evaporate quickly). It takes several hours to completely dry the IT equipment, which affects the normal maintenance of the server.

The two-phase immersed liquid-cooled system is cooled by its efficient and uniform phase change, there is no towing loss during maintenance (the liquid on the surface of the IT equipment evaporates quickly) and the maintenance is convenient, which makes the two-phase immersed liquid-cooled system more promising.

However, the existing two-phase immersed liquid-cooled solution places a plurality of IT servers in a large case ("pool") and requires filling a large amount of liquid to fill in the structural gap in the case, resulting in a large amount of liquid to fill in. However, the non-conductive fluorinated liquid itself is very expensive, which greatly increases the initial investment in immersed liquid-cooled equipment, thus making it significantly higher than the traditional air-cooled serve. The investment return rate is not desirable. Meanwhile, the huge case makes the surface of the fluorinated liquid evaporates quickly. Moreover, when a single IT server is under maintenance, other servers may have to be shut down too, otherwise there will be a greater amount of steam dissipation, which will greatly increase maintenance costs and manpower requirements, so that this immersed liquid-cooled solution cannot be conducted in a large scale.

In CN Patent No. 103616940, a blade server is provided, which includes at least one blade housing. Each blade housing contains at least one blade server motherboard and is filled with coolant.

In International Publication No. WO2014/039212, an apparatus and method for cooling of electronic equipment, for example a computer system, in a subsurface environment are provided, which include a containment vessel in at least partial contact with subsurface liquid or solid material.

In US Patent No. 8184436, apparatuses and methods for facilitating cooling of rack-mounted assemblages of individual electronic units, such as rack-mounted computer server units are provided.

In US Patent No. 4493010, an improved electronics packaging module is provided, in which the individual electronic components are contained in a sealed chamber containing a heat conducting liquid cooled by means of a phase change evaporator connected to an external compressor unit.

### SUMMARY OF THE INVENTION

In view of this, embodiments of the present invention are intended to provide a modular liquid-cooled server chassis to solve or alleviate the technical problems existing in the prior art, and at least to provide a beneficial choice.

The technical solution of the present invention is implemented as below:

According to the present invention, a modular liquid-cooled server chassis is provided, comprising:
a case;
one or more liquid-cooled modules, wherein each liquid-cooled module comprises: a housing, an gas outlet valve, and a liquid return valve, wherein the gas outlet valve and the liquid return valve are opened when the liquid-cooled module is in operation, and the liquid-cooled module is inserted with a single server during operation and is filled with coolant;
a connector for connecting the liquid-cooled module to an external power source; and
a circulation section comprises an gas outlet pipe, a liquid return pipe, a steam treatment zone, and a liquid collection zone, wherein,
   the gas outlet pipe is connected to the gas outlet valve and is used to transport gas from the liquid-cooled module to the steam treatment zone;
   the liquid return pipe is connected to the liquid return valve and is used to transport liquid from the liquid collection zone to the liquid-cooled module;
   the steam treatment zone is provided with a condenser for cooling the gas in the steam treatment zone; and
   the liquid collection zone is used for collecting liquid from the steam treatment zone.

In some embodiments, the chassis further comprises a power supply and control system including a power source and a controller, wherein,
the power source is connected to the connector for supplying power to other components in the chassis through the connector; and
the controller is used to control other components in the chassis.

In some embodiments, the steam treatment zone further comprises a pressure relief valve, and gas in the steam treatment zone can be discharged to the outside through the pressure relief valve.

In some embodiments, the pressure relief valve is further connected to an external air bag for collecting the gas discharged from the pressure relief valve.

In some embodiments, the case further comprises a liquid filling valve connected to the liquid collection zone, and the liquid collection zone may be supplemented with coolant by the liquid filling valve.

In some embodiments, each liquid-cooled module further comprises a first sensor connected to the controller and configured to detect a liquid level of the coolant in the liquid-cooled module; wherein,
when the liquid level of the coolant in the liquid-cooled module is higher than a first threshold, the first sensor generates a first signal and sends it to the controller, and the controller closes the liquid return valve after receiving the first signal; and
when the liquid level of the coolant in the liquid-cooled module is lower than a second threshold, the first sensor generates a second signal and sends it to the controller, and the controller opens the liquid return valve after receiving the second signal.

In some embodiments, the steam treatment zone further comprises a second sensor connected to the controller and configured to detect the gas pressure in the steam treatment zone; wherein,
when the gas pressure is greater than a third threshold, the second sensor generates a third signal and sends it to the controller, and the controller opens the pressure relief valve after receiving the third signal to depressurize.

In some embodiments, the liquid collection zone further comprises a third sensor connected to the controller and configured to detect the liquid level of the coolant in the liquid collection zone, wherein
when the liquid level of the coolant in the liquid collection zone is lower than a fourth threshold, the third sensor generates a fourth signal and sends it to the controller, and the controller generates an alarm signal after receiving the fourth signal, warning that the coolant needs to be filled.

In some embodiments, each liquid-cooled module further comprises a maintenance end cap that closes when the liquid-cooled module is in operation.

In some embodiments, the circulation section further comprises a first cooling pipe and a second cooling pipe; wherein,
the first cooling pipe and the second cooling pipe are connected to the condenser, and the first cooling pipe is used to transport the coolant in the condenser to the outside, and the second cooling pipe is used to transport the external coolant to the condenser.

In some embodiments, the first cooling pipe and the second cooling pipe are connected to an external heat exchange apparatus.

In some embodiments, the heat exchange apparatus is a dry cooler, a cooling tower, or a a chilled water system for a building.

In some embodiments, the coolant is cooling water.

In some embodiments, the connector is a quick plug-in device.

In some embodiments, the coolant is a fluorinated liquid.

Because the above technical solution is adopted in the present invention, it has the following advantages: with the modular liquid-cooled server chassis of the present invention, if it is desired to perform maintenance on a single server, it is only necessary to power off the server in operation, and close the gas outlet valve and the liquid return valve and pull out the liquid-cooled module, and then the server can be taken out separately Maintenance or replacement does not affect the operation of other servers. In addition, the condenser is installed outside the liquid-cooled module. The coolant cannot contaminate the server and enhances the reliability of the chassis.

The above summary is for the purpose of illustration only and is not intended to be limiting in any way. In addition to the illustrative aspects, embodiments, and features described above, further aspects, embodiments, and features of present invention will be readily apparent by reference to the drawings and the following detailed description.

### BRIEF DESCRIPTION OF THE DRAWINGS

In the drawings, the same reference numerals denote the same or similar parts or elements throughout all the drawings unless otherwise specified. The drawings are not necessarily drawn to scale. It should be understood that these drawings depict only some embodiments disclosed in accordance with present invention which is defined by the claims.
FIG. 1 is a schematic cross-sectional view of a modular liquid-cooled server chassis according to a first embodiment of the present invention;
FIG. 2 is a schematic sectional view of a liquid-cooled module according to a first embodiment of the present invention;
FIG. 3 is a schematic cross-sectional view of a modular liquid-cooled server chassis according to a second embodiment of the present invention;
FIG. 4 is a schematic sectional view of a liquid-cooled module according to a second embodiment of the present invention;
FIG. 5 is a schematic cross-sectional view of a modular liquid-cooled server chassis according to a third embodiment of the present invention.

### DETAILED DESCRIPTION OF THE EMBODIMENTS

In the following, only certain embodiments are briefly described. As can be recognized by those skilled in the art, various modifications may be made to the described embodiments within the definition of the invention as disclosed in the claims. Therefore, the drawings and the description are substantially regarded as exemplary intrinsically rather than restrictive.

In the description of the present application, "a plurality of" means two or more, unless expressly limited otherwise.

Those of ordinary skill in the art can understand the specific meanings of the above terms in the present invention according to specific circumstances within the scope of the amended claims.

The following disclosure provides many different embodiments or examples for implementing different structures of the present invention. In order to simplify the disclosure of the present invention, the components and settings of specific examples are described below. Of course, they are merely examples and it is not intended to limit the present invention which is limited by the scope of the claims. In addition, the present invention may repeat reference numerals and/or reference letters in different examples. This repetition is for the purpose of simplification and clarity and does not itself indicate the relationship between the various embodiments and/or settings discussed. In addition, the present invention provides examples of various specific processes and materials, but one of ordinary skill in the art may be aware of applications of other processes and/or use of other materials.

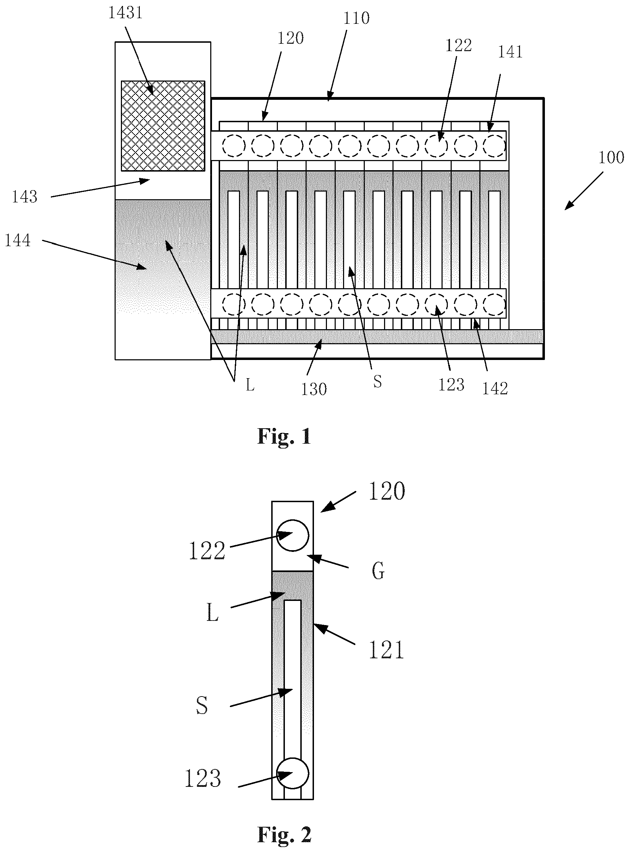

FIG. 1 is a schematic cross-sectional view of a modular liquid-cooled server chassis according to a first embodiment of the present invention. As shown in FIG. 1, the modular liquid-cooled server chassis 100 comprises:
a case 110, one or more liquid-cooled modules 120, a connector 130, and a circulation section.

The case 110 houses all components of the case therein, and an upper or side portion thereof may be provided with a cover (not shown) so that the operator can open the cover to inspect the components in the case 110 and replace the components.

One or more liquid-cooled modules 120 are provided inside the case 110. FIG. 2 shows a single liquid-cooled module including a housing 121, a gas outlet valve 122, and a liquid return valve 123, with a single server S is immersed in the coolant L.

When the liquid-cooled module 120 is operated, the single server S is completely immersed in the coolant L, and the gas outlet valve 122 and the liquid return valve 123 are opened. In general, the coolant is a low-boiling non-conductive liquid. Preferably, the coolant may be a fluorinated liquid. The fluorinated liquid is stable in performance, does not react with active materials such as metals, plastics, and elastomers, and has excellent non-conducting and insulating properties no matter at high temperatures or at low temperatures. Thus it can be widely used to cool electronic devices. In the present invention, the specific type of fluorinated liquid is not defined.

The connector 130 is used to connect the liquid-cooled module to an external power source. The specific type of connector 130 is not defined in the present invention. Preferably, the connector 130 may be a quick plug-in device, such as a power strip, to enable quick insertion and removal of the liquid-cooled module 120.

The circulation section comprises a gas outlet pipe 141, a liquid return pipe 142, a steam treatment zone 143, and a liquid collection zone 144.

As shown in FIG. 1, the gas outlet pipe 141 is located in the upper portion of the liquid-cooled module, and the gas outlet valve 122 of each liquid-cooled module 120 is connected to the gas outlet pipe 141, whereas the liquid return valve 123 of each liquid-cooled module 120 is connected to the liquid return pipe 142 located in the lower portion of the liquid-cooled module 120. Due to the angle from which to observe, the gas outlet pipe 141 and the liquid return pipe 142 cover the gas outlet valve 122 and the gas outlet valve 123, both of which are shown in dotted lines in FIG. 1, for the convenience of description.

When the chassis 100 is in operation, the liquid-cooled module 120 is plugged onto the connector 130, and the gas outlet valve 122 and the liquid return valve 123 are opened. The connector 130 is connected to an external power source to provide power to the liquid-cooled module 120 and the server S. With the operation of the server S, the internal chip temperature gradually rises to reach the boiling point of the coolant L. At this point, the coolant is vaporized and the heat from the chip and other parts of the server is taken away by the latent heat. The bubble of coolant after vaporization floats from the coolant and is distributed to the gas zone G in the upper portion of the liquid-cooled module (as shown in FIG. 2), and then passes through the gas outlet valve 122 into the gas outlet pipe 141 of the circulation section. The bubble, together with the coolant gases generated by other liquid-cooled modules is sent to the steam treatment zone 143. The steam treatment zone 143 is provided with a condenser 1431 which cools the coolant gas back into coolant. The re-condensed coolant droplets fall into the liquid collection zone 144 and can be transported to the liquid return valve 123 of each liquid-cooled module through the liquid return pipe 142 and enter the liquid-cooled module through the valve to complete the circulation of the coolant.

Ten liquid-cooled modules are shown in FIG.1. It can be understood that other quantities of liquid-cooled modules can be applied in the case 110 depending on actual needs, and the size of the case 110 may also change accordingly, and the size and power of the condenser also need to be adjusted accordingly. Therefore, depending on the difference of environments, differently-sized cases can be provided, wherein the internal contains different quantities of liquid-cooled modules and condensers of different sizes and power. For example, a large data center uses a very large number of servers, so it can equipped with a larger chassis, which contains dozens or even hundreds of liquid-cooled modules, while including a relatively high power condenser. For the average users, it is possible to provide a small chassis that contains a small number of liquid-cooled modules and a relatively low power condenser.

In the present invention, by means of the circulation section, the coolant can complete the circulation in the chassis, which improves the usage ratio of the coolant.

The condenser 1431 may be condenser of any type, for example, it may be a condensation tray, and the present invention does not specifically define herein.

If it is necessary to maintain a single server, then just turn the single server off. Meanwhile, the liquid-cooled module 120 in which the server is located is disconnected from the connector 130, and then the gas outlet valve 122 and the liquid return valve 123 of the liquid-cooled module 120 are closed, which means that the liquid-cooled module 120 can be withdrawn the case 110 now. At this point, the other servers are still operating normally and are not affected. After withdrawing the liquid-cooled module 120, the server S can be withdrawn from the coolant for maintenance or replacement.

When reinstalling the server S, the serviced or replaced server may be re-disposed in the liquid-cooled module 120, and the gas outlet valve 122 and the liquid return valve 123 of the liquid-cooled module 120 may be re-connected to the chassis and being opened as well. At this time, according to the liquid level pressure balance principle, the coolant in the liquid collection zone 140 will pass through the liquid return pipe 142 and enter the liquid-cooled module 120 via the liquid return valve 123. After the coolant highly satisfies the requirements of the server, the liquid-cooled module 120 can be connected to the connector 130 and re-power it to make it work properly.

It can be seen that using the modular liquid-cooled server chassis according to the present invention, a single server can be maintained without affecting other servers, and the condenser is located outside the liquid-cooled module, so that the server can be protected from the contamination of the coolant in the condenser.

In particular, the coolant may be cooling water.

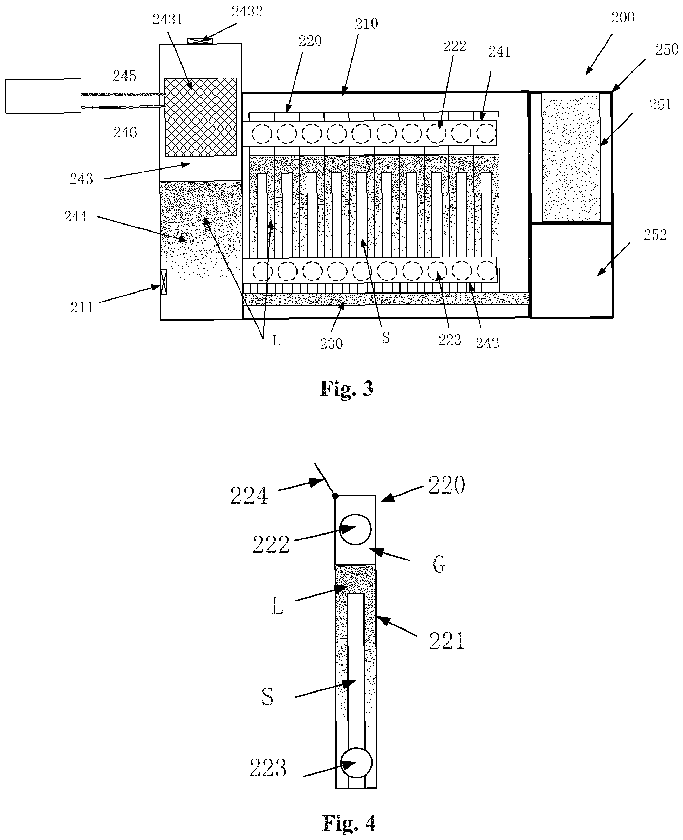

FIG. 3 shows a schematic cross-sectional view of a modular liquid-cooled server chassis 200 according to a second embodiment of the present invention. The same parts of the chassis 200 as those of the chassis 100 will not be described herein again, and only the differences therebetween will be specifically described.

In the chassis 200, as shown in FIG. 4, the liquid-cooled module 220 further comprises a maintenance end cover 224, which is closed when the liquid-cooled module is in operation. In this way, if the maintenance of the server is required, when the cover of the chassis is opened and the liquid-cooled module is withdrawn therein, part of the coolant will leak. However, only the coolant in this particular liquid-cooling module 220 will leak, and no coolant or cooling gas from other liquid-cooling modules will be at loss.

As shown in FIG. 3, the circulation section of the cabinet 200 may further include a first cooling pipe 245 and a second cooling pipe 246, and the first and second cooling pipes 245 and 246 are both connected to the condenser 2431 and the external heat exchange apparatus. Wherein, the first cooling pipe transports the hot coolant in the condenser 2431 to the external heat exchange apparatus, and the second cooling pipe transports the new coolant from the external heat exchange apparatus to the condenser 2431, thereby completing the replacement of the coolant.

In the present invention, the heat exchange apparatus is provided outside the chassis 200, but it can be understood that the chassis 200 itself may also contain the heat exchange apparatus. In addition, the heat exchange apparatus may be of any type, such as a dry cooler, a cooling tower or a chilled water system for a building.

In addition, chassis 200 also comprises a power supply and control system 250. As shown in FIG. 3, the power supply and control system 250 comprises a power source 251 and a controller 252. The power source 251 is connected to the connector 230 to power the various components of the chassis 200 through the connector 130. The controller is connected to various components of the chassis to control them respectively. For example, the opening and closing of the various valves of the liquid-cooled module 220, and the power-off and power-on of the liquid-cooled module 220 may be controlled, so as to operate the chassis 200 more conveniently.

Preferably, as shown in FIG. 3, the case 210 may further include a liquid filling valve 211 connected to the liquid collection zone 244. Through the liquid filling valve 211 the liquid collection zone 244 may be supplemented with coolant, so as to avoid opening the chassis to fill in coolant, which is of convenience to the user.

In addition, at some point, the server generates too much steam to cool timely and effectively. At this time, the pressure in the steam treatment zone 243 rises, which, thereby, affects the cooling effect, and may even damage the condenser 2431. For this purpose, the steam treatment zone 143 preferably comprises a pressure relief valve 2432. Through the pressure relief valve 2432, the steam treatment zone 243 can be depressurized, avoiding problems caused by excessive pressure.

The exiting gas may be discharged to the external environment due to the pressure relief, but preferably may be recovered by an air bag (not shown), and the recovered gas may be re-cooled into coolant, which thereafter, may also be re-filled into the liquid collection zone through the liquid filling valve 211 for recycling so as to improve the usage ratio of coolant. It can be understood that the air bag can also be contained inside the chassis. In this case, the air bag may be connected to the cooling device, or a cooling device may be provided inside the air bag. After the gas in the air bag is cooled to coolant, the air bag may be connected to the liquid filling zone for reuse by another pipeline for recycling usage.

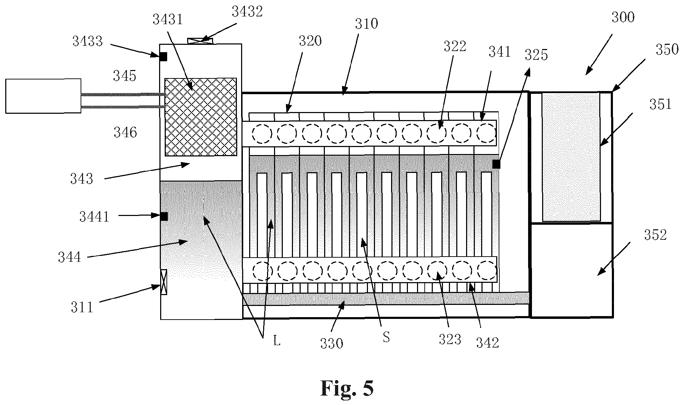

FIG. 5 shows a schematic cross-sectional view of a modular liquid-cooled server chassis 300 according to a third embodiment of the invention. The chassis 300 differs from the chassis 200 shown in FIG. 2 in that sensors may be included in the liquid-cooled module 320, the steam treatment zone 343, and the liquid collection zone 344 of the chassis 300. In addition to that, the rest of the chassis 300 is the same as the chassis 200 and therefore will not be described again.

It can be understood that sensors can be provided in one or more of the above three components, which is not limited by the present invention. For ease of illustration, sensors are provided in three components of the chassis 300 in FIG. 4, which are represented by a first sensor 325, a second sensor 3433, and a third sensor 3441 respectively.

The first, second, and third sensors 325, 3433, and 3441 are each connected to a controller 352, which may be any type of sensor such as a contact-type depth sensor, a pressure sensor, etc., and it can be understood that these sensors can also be a non-contact sensor (such as a laser sensor, an infrared sensor, etc.) provided on the wall of the chassis.

The first sensor 325 is provided in each liquid-cooled module 320 for detecting the liquid level of the coolant in the liquid-cooled module 320. After the server completes the maintenance and reinserts the liquid-cooled module 320, the liquid-cooled module 320 is re-filled with coolant. When the first sensor 325 detects that the liquid level of the coolant in the liquid-cooled module 320 exceeds the first threshold, it will generate a first signal to notify the controller 352, and the controller 352 will close the liquid return valve 323 according to the signal and stop the coolant from entering. Also, if the first sensor 325 detects that the liquid level in the liquid-cooled module 320 is lower than the second threshold, a second signal will be generated to notify the controller 352. The controller 352 will open the liquid return valve according to the signal, and supplement coolant for the liquid-cooled module. In this way, the liquid level of the coolant in the liquid-cooled module can be maintained within a certain range. The first and second thresholds are predetermined according to the amount of coolant required to cool the server.

The second sensor 3433 is provided in the steam treatment zone 343 for detecting the gas pressure in the steam treatment zone 343. When the gas pressure exceeds the third threshold, the second sensor 3433 generates a third signal to notify the controller 352 so that the controller will open the pressure relief valve 3433 according to the signal and depressurize the steam treatment zone 343 .

The third sensor 3441 is provided in the liquid collection zone 344 for detecting the liquid level of the coolant in the liquid collection zone 344. When the liquid level falls below the fourth threshold, a signal is generated to notify the controller 352, and the controller 352 will send an alarm signal according to the signal, warning that the coolant needs to be filled. Then the coolant can be filled through the liquid filling port 311 to avoid problems due to lack of coolant.

Wherein, the third and fourth threshold can be predetermined according to actual needs, and the present invention does not specifically set any limitations.

## Claims

1. A modular liquid-cooled server chassis, (100, 200, 300), wherein the chassis (100, 200, 300) comprises:
a case 110, 210, 310);
one or more liquid-cooled modules (120, 220, 320),
wherein each liquid-cooled module (120, 220, 320) comprises a housing (121, 221, 321), a gas outlet valve (122, 222, 322)
and a liquid return valve (1 23, 233, 333) , wherein the gas outlet valve (122, 222, 322) and the liquid return valve (123, 233, 333) are opened when the liquid-cooled module (122, 222, 322) is in operation, and the liquid-cooled module (120, 220, 320) is inserted with a single server during operation and is filled with coolant;
a connector (130, 230, 330) for connecting the liquid-cooled module (120, 220, 320) to an external power source; and
a circulation section comprising a gas outlet pipe (141, 241, 341)
a liquid return pipe (142, 242, 342), a steam treatment zone (143, 243, 343), and a liquid collection zone (144, 244, 344) , wherein,
the gas outlet pipe (141, 241, 341) is connected to the gas outlet valve (122, 222, 322) and is used to transport gas from the liquid-cooled module (120, 220, 320) to the steam treatment zone (143, 243, 343) ;
the liquid return pipe (142, 242, 342) is connected to the liquid return valve (123, 223, 323) and is used to transport liquid from the liquid collection zone (144, 244, 344) to the liquid-cooled module (120, 220, 320) ;
the steam treatment zone (143, 243, 343) is provided with a condenser (1431, 2431, 3431) for cooling the gas in the steam treatment zone (143, 243, 343) ; and
the liquid collection zone (144, 244, 344) is used for collecting liquid from the steam treatment zone (143, 243, 343) .

2. The server chassis of claim 1, wherein the chassis (200) further comprises a power supply and control system (250) including a power source (251) and a controller (252), wherein
the power source (251) is connected to the connector (130) for supplying power to other components in the chassis (200) through the connector (130); and
the controller (252) is used to control other components in the chassis (200).

3. The server chassis of claim 2, wherein the steam treatment zone (143) further comprises a pressure relief valve (2432), and gas in the steam treatment zone (143) can be discharged to the outside through the pressure relief valve (2432).

4. The server chassis of claim 3, wherein the pressure relief valve (2432) is further connected to an external air bag for collecting the gas discharged from the pressure relief valve (2432).

5. The server chassis of claim 1 or 2, wherein the case (100) further comprises a liquid filling valve (211) connected to the liquid collection zone (144), and the liquid collection zone (144) may be supplemented with coolant by the liquid filling valve (211).

6. The server chassis of claim 2, wherein each liquid-cooled module (120) further comprises a first sensor (325) connected to the controller (252) and configured to detect a liquid level of the coolant in the liquid-cooled module (120);
when the liquid level of the coolant in the liquid-cooled module (120) is higher than a first threshold, the first sensor (325) generates a first signal and sends it to the controller (252), and the controller (252) closes the liquid return valve (123) after receiving the first signal; and
when the liquid level of the coolant in the liquid-cooled module (120) is lower than a second threshold, the first sensor (325) generates a second signal and sends it to the controller (252), and the controller (252) opens the liquid return valve (123) after receiving the second signal.

7. The server chassis of claim 3, wherein the steam treatment zone (143) further comprises a second sensor (3433) connected to the controller (252) and configured to detect the gas pressure in the steam treatment zone (143); wherein,
when the gas pressure is greater than a third threshold, the second sensor (3433) generates a third signal and sends it to the controller (252), and the controller (252) opens the pressure relief valve (2432) after receiving the third signal to depressurize.

8. The server chassis of claim 2, wherein the liquid collection zone (144) further comprises a third sensor (3441) connected to the controller (252) and configured to detect the liquid level of the coolant in the liquid collection zone (144), wherein,
when the liquid level of the coolant in the liquid collection zone (144) is lower than a fourth threshold, the third sensor (3441) generates a fourth signal and sends it to the controller (252), and the controller (252) generates an alarm signal after receiving the fourth signal, warning that the coolant needs to be filled.

9. The server chassis of claim 1, wherein each liquid-cooled module (120) further comprises a maintenance end cap that closes when the liquid-cooled module (120) is in operation.

10. The server chassis of claim 1, wherein the circulation section further comprises a first cooling pipe (245) and a second cooling pipe (246); wherein
the first cooling pipe (245) and the second cooling pipe (246) are connected to the condenser (1431), and the first cooling pipe (245) is used to transport the coolant in the condenser (1431) to the outside, and the second cooling pipe (246) is used to transport the external coolant to the condenser (1431).

11. The server chassis of claim 10, wherein the first cooling pipe (245) and the second cooling pipe (246) are connected to an external heat exchange apparatus.

12. The server chassis of claim 11, wherein the heat exchange apparatus is a dry cooler, a cooling tower, or a chilled water system for a building.

13. The server chassis of claim 10, wherein the coolant is cooling water.

14. The server chassis of claim 1, wherein the connector (130) is a quick plug-in device.

15. The server chassis of claim 1, wherein the coolant is fluorinated liquid.

## Patentansprüche

1. Modulares flüssigkeitsgekühltes Servergerüst (100, 200, 300), wobei das Gerüst (100, 200, 300) Folgendes umfasst:
ein Behältnis (110, 210, 310);
ein oder mehrere flüssigkeitsgekühlte Module (120, 220, 320), wobei jedes flüssigkeitsgekühlte Modul (120, 220, 320) ein Gehäuse (121, 221, 321), ein Gasauslassventil (122, 222, 322) und ein Flüssigkeitsrücklaufventil (123, 233, 333) umfasst, wobei das Gasauslassventil (122, 222, 322) und das Flüssigkeitsrücklaufventil (123, 233, 333) geöffnet sind, wenn das flüssigkeitsgekühlte Modul (122, 222, 322) in Betrieb ist, und das flüssigkeitsgekühlte Modul (120, 220, 320) während des Betriebs mit einem einzigen Server eingesetzt und mit Kühlmittel gefüllt ist;
einen Verbinder (130, 230, 330) zum Verbinden des flüssigkeitsgekühlten Moduls (120, 220, 320) mit einem externen Netzteil;
und
einen Zirkulationsabschnitt, umfassend eine Gasauslassleitung (141, 241, 341), eine Flüssigkeitsrücklaufleitung (142, 242, 342), eine Dampfbehandlungszone (143, 243, 343) und eine Flüssigkeitssammelzone (144, 244, 344), wobei
die Gasauslassleitung (141, 241, 341) ist mit dem Gasauslassventil (122, 222, 322) verbunden und wird verwendet, um Gas aus dem flüssigkeitsgekühlten Modul (120, 220, 320) zu der Dampfbehandlungszone (143, 243, 343) zu transportieren;
die Flüssigkeitsrücklaufleitung (142, 242, 342) ist mit dem Flüssigkeitsrücklaufventil (123, 223, 323) verbunden und wird verwendet, um Flüssigkeit aus der Flüssigkeitssammelzone (144, 244, 344) zu dem flüssigkeitsgekühlten Modul (120, 220, 320) zu transportieren;
die Dampfbehandlungszone (143, 243, 343) mit einem Kondensator (1431, 2431, 3431) zum Kühlen des Gases in der Dampfbehandlungszone (143, 243, 343) versehen ist; und
die Flüssigkeitssammelzone (144, 244, 344) zum Sammeln von Flüssigkeit aus der Dampfbehandlungszone (143, 243, 343) verwendet wird.

2. Servergerüst nach Anspruch 1, wobei das Gerüst (200) ferner ein Netzteil- und Steuersystem (250) umfasst, das ein Netzteil (251) und eine Steuerung (252) beinhaltet, wobei
das Netzteil (251) mit dem Verbinder (130) verbunden ist, um andere Komponenten in dem Gerüst (200) über den Verbinder (130) mit Strom zu versorgen; und
die Steuerung (252) verwendet wird, um andere Komponenten in dem Gerüst (200) zu steuern.

3. Servergerüst nach Anspruch 2, wobei die Dampfbehandlungszone (143) ferner ein Druckentlastungsventil (2432) umfasst und Gas in der Dampfbehandlungszone (143) durch das Druckentlastungsventil (2432) nach außen abgeleitet werden kann.

4. Servergerüst nach Anspruch 3, wobei das Druckentlastungsventil (2432) ferner mit einem externen Luftsack zum Sammeln des von dem Druckentlastungsventil (2432) abgeleiteten Gases verbunden ist.

5. Servergerüst nach Anspruch 1 oder 2, wobei das Behältnis (100) ferner ein Flüssigkeitsfüllventil (211) umfasst, das mit der Flüssigkeitssammelzone (144) verbunden ist, und die Flüssigkeitssammelzone (144) durch das Flüssigkeitsfüllventil (211) mit Kühlmittel aufgefüllt werden kann.

6. Servergerüst nach Anspruch 2, wobei jedes flüssigkeitsgekühlte Modul (120) ferner einen ersten Sensor (325) umfasst, der mit der Steuerung (252) verbunden und konfiguriert ist, um einen Flüssigkeitsstand des Kühlmittels in dem flüssigkeitsgekühlten Modul (120) zu erfassen;
wenn der Flüssigkeitsstand des Kühlmittels in dem flüssigkeitsgekühlten Modul (120) höher ist als ein erster Schwellenwert ist, der erste Sensor (325) ein erstes Signal erzeugt und es an die Steuerung (252) sendet, und nach Empfangen des ersten Signals die Steuerung (252) das Flüssigkeitsrücklaufventil (123) schließt; und
wenn der Flüssigkeitsstand des Kühlmittels in dem flüssigkeitsgekühlten Modul (120) niedriger ist als ein zweiter Schwellenwert ist, erzeugt der erste Sensor (325) ein zweites Signal und sendet es an die Steuerung (252), und die Steuerung (252) nach Empfangen des zweiten Signals das Flüssigkeitsrücklaufventil (123) öffnet.

7. Servergerüst nach Anspruch 3, wobei die Dampfbehandlungszone (143) ferner einen zweiten Sensor (3433) umfasst, der mit der Steuerung (252) verbunden und konfiguriert ist, um den Gasdruck in der Dampfbehandlungszone (143) zu erfassen; wobei
wenn der Gasdruck größer ist als ein dritter Schwellenwert, der zweite Sensor (3433) ein drittes Signal erzeugt und es an die Steuerung (252) sendet, und die Steuerung (252) nach Empfangen des dritten Signals das Überdruckventil (2432) öffnet, um den Druck abzubauen.

8. Servergerüst nach Anspruch 2, wobei die Flüssigkeitssammelzone (144) ferner einen dritten Sensor (3441) umfasst, der mit der Steuerung (252) verbunden und konfiguriert ist, um den Flüssigkeitsstand des Kühlmittels in der Flüssigkeitssammelzone (144) zu erfassen, wobei
wenn der Flüssigkeitsstand des Kühlmittels in der Flüssigkeitssammelzone (144) niedriger ist als ein vierter Schwellenwert, der dritte Sensor (3441) ein viertes Signal erzeugt und es an die Steuerung (252) sendet, und die Steuerung (252) nach Empfangen des vierten Signals ein Alarmsignal erzeugt, das darauf hinweist, dass das Kühlmittel aufgefüllt werden muss.

9. Servergerüst nach Anspruch 1, wobei jedes flüssigkeitsgekühlte Modul (120) ferner eine Wartungsendkappe umfasst, die geschlossen wird, wenn das flüssigkeitsgekühlte Modul (120) in Betrieb ist.

10. Servergerüst nach Anspruch 1, wobei der Zirkulationsabschnitt ferner eine erste Kühlleitung (245) und eine zweite Kühlleitung (246) umfasst; wobei
die erste Kühlleitung (245) und die zweite Kühlleitung (246) mit dem Kondensator (1431) verbunden sind, und die erste Kühlleitung (245) dazu dient, das Kühlmittel in dem Kondensator (1431) nach außen zu transportieren, und die zweite Kühlleitung (246) dazu dient, das externe Kühlmittel zu dem Kondensator (1431) zu transportieren.

11. Servergerüst nach Anspruch 10, wobei die erste Kühlleitung (245) und die zweite Kühlleitung (246) mit einer externen Wärmeaustauschvorrichtung verbunden sind.

12. Servergerüst nach Anspruch 11, wobei die Wärmeaustauschvorrichtung ein Trockenkühler, ein Kühlturm oder ein Kaltwassersystem für ein Gebäude ist.

13. Servergerüst nach Anspruch 10, wobei das Kühlmittel Kühlwasser ist.

14. Servergerüst nach Anspruch 1, wobei der Verbinder (130) eine Schnellsteckvorrichtung ist.

15. Servergerüst nach Anspruch 1, wobei das Kühlmittel eine fluorierte Flüssigkeit ist.

## Revendications

1. Un châssis de serveur modulaire refroidi par liquide (100, 200, 300), dans lequel le châssis (100, 200, 300) comprend :
un boîtier (110, 210, 310) ;
un ou plusieurs modules refroidis par liquide (120, 220, 320), dans lequel chaque module refroidi par liquide (120, 220, 320) comprend un logement (121, 221, 321), une soupape de sortie de gaz (122, 222, 322) et une soupape de retour de liquide (123, 233, 333), dans lequel la soupape de sortie de gaz (122, 222, 322) et la soupape de retour de liquide (123, 233, 333) sont ouvertes lorsque le module refroidi par liquide (122, 222, 322) est en fonctionnement, et le module refroidi par liquide (120, 220, 320) est inséré avec un seul serveur pendant le fonctionnement et est rempli d'un agent de refroidissement ;
un connecteur (130, 230, 330) destiné à raccorder le module refroidi par liquide (120, 220, 320) à une source d'alimentation externe ;
et
une zone de circulation comprenant un tuyau de sortie de gaz (141, 241, 341), un tuyau de retour de liquide (142, 242, 342), une zone de traitement de vapeur (143, 243, 343) et une zone de collecte de liquide (144, 244, 344), dans lequel
le tuyau de sortie de gaz (141, 241, 341) est relié à la soupape de sortie de gaz (122, 222, 322) et sert à transporter du gaz depuis le module refroidi par liquide (120, 220, 320) jusqu'à la zone de traitement de vapeur (143, 243, 343) ;
le tuyau de retour de liquide (142, 242, 342) est relié à la soupape de retour de liquide (123, 223, 323) et sert à transporter du liquide depuis la zone de collecte de liquide (144, 244, 344) jusqu'au module refroidi par liquide (120, 220, 320) ;
la zone de traitement de vapeur (143, 243, 343) est pourvue d'un condenseur (1431, 2431, 3431) destiné à refroidir le gaz dans la zone de traitement de vapeur (143, 243, 343) ; et
la zone de collecte de liquide (144, 244, 344) sert à collecter le liquide issu de la zone de traitement de vapeur (143, 243, 343).

2. Le châssis de serveur de la revendication 1, dans lequel le châssis (200) comprend en outre un système d'alimentation et de commande (250) comprenant une source d'alimentation (251) et un dispositif de commande (252), dans lequel
la source d'alimentation (251) est raccordée au connecteur (130) pour alimenter d'autres composants situés dans le châssis (200) par l'intermédiaire du connecteur (130) ; et
le dispositif de commande (252) sert à commander d'autres composants situés dans le châssis (200).

3. Le châssis de serveur de la revendication 2, dans lequel la zone de traitement de vapeur (143) comprend en outre une soupape de surpression (2432), et du gaz présent dans la zone de traitement de vapeur (143) peut être évacué vers l'extérieur par la soupape de surpression (2432).

4. Le châssis de serveur de la revendication 3, dans lequel la soupape de surpression (2432) est en outre reliée à un sac gonflable externe pour collecter le gaz évacué par la soupape de surpression (2432).

5. Le châssis de serveur de la revendication 1 ou 2, dans lequel le boîtier (100) comprend en outre une soupape de remplissage de liquide (211) reliée à la zone de collecte de liquide (144), et la zone de collecte de liquide (144) peut être alimentée en agent de refroidissement par la soupape de remplissage de liquide (211).

6. Le châssis de serveur de la revendication 2, dans lequel chaque module refroidi par liquide (120) comprend en outre un premier capteur (325) relié au dispositif de commande (252) et conçu pour détecter un niveau de liquide de l'agent de refroidissement dans le module refroidi par liquide (120) ;
lorsque le niveau de liquide de l'agent de refroidissement dans le module refroidi par liquide (120) est supérieur à un premier seuil, le premier capteur (325) génère un premier signal et envoie celui-ci au dispositif de commande (252), et le dispositif de commande (252) ferme la soupape de retour de liquide (123) après avoir reçu le premier signal ; et
lorsque le niveau de liquide de l'agent de refroidissement dans le module refroidi par liquide (120) est inférieur à un deuxième seuil, le premier capteur (325) génère un deuxième signal et envoie celui-ci au dispositif de commande (252), et le dispositif de commande (252) ouvre la soupape de retour de liquide (123) après avoir reçu le deuxième signal.

7. Le châssis de serveur de la revendication 3, dans lequel la zone de traitement de vapeur (143) comprend en outre un deuxième capteur (3433) relié au dispositif de commande (252) et conçu pour détecter la pression gazeuse dans la zone de traitement de vapeur (143) ; dans lequel,
lorsque la pression gazeuse est supérieure à un troisième seuil, le deuxième capteur (3433) génère un troisième signal et envoie celui-ci au dispositif de commande (252), et le dispositif de commande (252) ouvre la soupape de surpression (2432) après avoir reçu le troisième signal afin de réduire la pression.

8. Le châssis de serveur de la revendication 2, dans lequel la zone de collecte de liquide (144) comprend en outre un troisième capteur (3441) relié au dispositif de commande (252) et conçu pour détecter le niveau de liquide de l'agent de refroidissement dans la zone de collecte de liquide (144), dans lequel,
lorsque le niveau de liquide de l'agent de refroidissement dans la zone de collecte de liquide (144) est inférieur à un quatrième seuil, le troisième capteur (3441) génère un quatrième signal et envoie celui-ci au dispositif de commande (252), et le dispositif de commande (252) génère un signal d'alarme après avoir reçu le quatrième signal, avertissant que l'agent de refroidissement doit être rempli.

9. Le châssis de serveur de la revendication 1, dans lequel chaque module refroidi par liquide (120) comprend en outre un obturateur d'extrémité de maintenance qui se ferme lorsque le module refroidi par liquide (120) est en fonctionnement.

10. Le châssis de serveur de la revendication 1, dans lequel la zone de circulation comprend en outre un premier tuyau de refroidissement (245) et un deuxième tuyau de refroidissement (246) ; dans lequel
le premier tuyau de refroidissement (245) et le deuxième tuyau de refroidissement (246) sont reliés au condenseur (1431), et le premier tuyau de refroidissement (245) sert à transporter l'agent de refroidissement du condenseur (1431) vers l'extérieur, et le deuxième tuyau de refroidissement (246) sert à transporter l'agent de refroidissement externe jusqu'au condenseur (1431).

11. Le châssis de serveur de la revendication 10, dans lequel le premier tuyau de refroidissement (245) et le deuxième tuyau de refroidissement (246) sont reliés à un appareil d'échange de chaleur externe.

12. Le châssis de serveur de la revendication 11, dans lequel l'appareil d'échange de chaleur est un refroidisseur à sec, une tour de refroidissement ou un système d'eau réfrigérée pour bâtiment.

13. Le châssis de serveur de la revendication 10, dans lequel l'agent de refroidissement est de l'eau de refroidissement.

14. Le châssis de serveur de la revendication 1, dans lequel le connecteur (130) est un dispositif à branchement rapide.

15. Le châssis de serveur de la revendication 1, dans lequel l'agent de refroidissement est un liquide fluoré.
